# EUROPEAN PATENT SPECIFICATION

(11) **EP 3 648 184 B1**
(45) Date of publication and mention of the grant of the patent: **30.09.2026**
(21) Application number: 19204743.9
(22) Date of filing: 23.10.2019
(51) Int. Cl.: H10H 29/85, H10H 20/852

(54) **LIGHTING MODULE**
BELEUCHTUNGSMODUL
MODULE D'ÉCLAIRAGE

(30) Priority: 31.10.2018 US 201862753252 P; 22.01.2019 US 201962795321 P
(43) Date of publication of application: 06.05.2020
(73) Proprietor: Everlight Electronics Co., Ltd., New Taipei City 23860 (TW)
(72) Inventor: LIN, Chun-Min, 23860 New Taipei City (TW); JIANG, Bo Cheng, 23860 New Taipei City (TW); KAO, Shang-Fu, 23860 New Taipei City (TW); CHEN, Yu Ju, 23860 New Taipei City (TW); LAI, Jen-hsiung, 23860 New Taipei City (TW); HSIEH, Chung Chuan, 23860 New Taipei City (TW)
(74) Representative: Becker Kurig & Partner Patentanwälte mbB

(56) References cited:
- WO-A2-2005/027576
- DE-A1- 102014 106 882
- TW-A- 201 237 300
- US-A1- 2007 284 589
- US-A1- 2015 129 914

## Description

### BACKGROUND OF THE INVENTION

### Field of the Invention

The present invention relates to a lighting module, and more particularly, relates to lighting devices having a large viewing angle and a lighting module using the lighting device.

### Descriptions of the Related Art

As LCD TVs and mobile devices continue to develop towards a low profile, lighting devices, as back-light sources thereof, also need to be miniaturized. Currently, Light Emitting Diode (LED) dies are mainly used as the back-light sources, because LED dies feature a high efficiency, high brightness, a high reliability and a fast response time or the like in addition to a small size. These LED dies are packaged to form lighting devices, and then the lighting devices are arranged intermittently on a substrate. These lighting devices can emit light to optical elements such as a liquid crystal layer, and then images are formed for viewing by users. In addition, to enhance the contrast of the displayed images, the local dimming technology is applied so that the lighting devices that correspond to the black part of the images do not emit light.

In such back-light applications, the number of the lighting devices can be reduced and the optical distance required for mixing the light can also be reduced, if the lighting devices have larger viewing angles. Currently, the lighting devices are often packaged in the form of reflector cups, because the manufacturing technology thereof is mature and the cost thereof is lower. However, the viewing angle of such lighting devices is only about 120 degrees. For this reason, secondary optical designs are required to increase the viewing angle to 140~160 degrees. That is, the light is diffused through an additional optical lens. However, for light-weight displays, the limited space thereof is not suitable for further installation of the optical lens, which will increase the production cost. However, if no optical lens is disposed, then a large number of lighting devices are needed, which increases the production cost.

Therefore, in the technical field of the lighting device, there are still problems to be solved.

DE 10 2014 106882 A1 discloses an optoelectronic component including a housing, wherein a cavity is formed on an upper side of the housing, which is delimited by a wall, the housing has an empty space, the wall is arranged between the cavity and the empty space, the housing has a surface, the empty space is arranged between the surface of the housing and the wall, the wall and the surface are arranged at least partially parallel to each other, the wall includes an optically transparent material, and the wall has a wall thickness of 1 µm to 100 µm.

US 2015/129914 A1 discloses a light-emitting diode package. The light-emitting diode package includes a lead frame having a first lead and a second lead separated from each other by a space. A transparent plastic housing surrounds and encapsulates the lead frame to form a cup-shaped body having a recessed accommodating space. A bottom of the space is defined as a function area. The function area comprises an exposed surface of the first lead and an exposed surface of the second lead. A top of the space is defined as an opening for light emission. A light-emitting diode chip is mounted on the first lead in the function area, electrically connected to the second lead.

WO 2005/027576 A2 discloses light efficient packaging configurations for LED lamps using high refractive index encapsulants. The packaging configurations including dome (bullet) shaped LED's, SMD (surface mount device) LED's and a hybrid LED type, including a dome mounted within a SMD package.

### SUMMARY OF THE INVENTION

An objective of the present invention is to provide lighting devices and a lighting module, and the lighting device may have a larger viewing angle (which may for example be up to 140~160 degrees), thereby reducing the number required for constituting the lighting module or reduce the optical distance required.

To achieve the aforesaid objective, the present invention is provided by the appended claims. Accordingly, the lighting module disclosed by the present invention comprises: a circuit substrate (21); a plurality of lighting devices (10) disposed on the circuit substrate (21) and electrically connected with the circuit substrate (21); and a light diffuser plate (22) disposed above the lighting devices (10), each of the lighting devices (10) comprising: an LED die (12), comprising a light-emitting top surface (121) and a plurality of light- emitting side surfaces (122), the light-emitting top surface (121) being connected with the light-emitting side surfaces (122); a light-transmissive encapsulant (13), covering the light-emitting side surfaces (122) and the light-emitting top surface (121) of the LED die (12), and comprising a plurality of side surfaces (133) connected with each other, a top surface (131) and a bottom surface (132); a light-transmissive wall (14), surrounding the light-transmissive encapsulant (13), covering the side surfaces (133) of the light-transmissive encapsulant (13); wherein the light-transmissive wall (14) comprises an externally exposed side surface (142), and a refractive index of the light-transmissive encapsulant (13) is less than a refractive index of the light-transmissive wall (14); and a lead frame structure (11), wherein the LED die (12) is disposed on the lead frame structure (11) and is electrically connected with the lead frame structure (11), while the light-transmissive encapsulant (13) and the light-transmissive wall (14) are disposed on the lead frame structure (11), wherein in the lighting module (20) in a normal direction of the light-emitting top surface (121) of the LED die (12) of the lighting device (10), there is a vertical distance between the light diffuser plate and the circuit substrate, and in a lateral direction that is orthogonal to the normal direction, there is a lateral distance between the lighting devices (10); and a ratio of the vertical distance to the lateral distance ranges from 0.1 to 0.8.

According to an embodiment of the present invention, an angle may be defined between the side surface and the bottom surface, and the angle ranges from 90 degrees to 160 degrees.

According to an embodiment of the present invention, the light-transmissive wall may comprise a filling material for increasing the structural strength, or the light-transmissive encapsulant may comprise a photoluminescence material. Moreover, any of the light-transmissive encapsulant and the light-transmissive wall may include a thermoplastic resin or a thermosetting resin.

According to an embodiment of the present invention, the top surface of the light-transmissive encapsulant may be a concave surface or a flat surface. Moreover, the light-transmissive encapsulant may further comprise a lens. The lens may comprise a concave portion.

According to an embodiment of the present invention, the lighting device may further comprise a reflective layer, wherein the reflective layer is located above the light-emitting top surface of the LED die, and shields the light-emitting top surface in a normal direction of the light-emitting top surface. Moreover, the reflective layer may be disposed on the top surface of the light-transmissive encapsulant or disposed on the light-emitting top surface of the LED die.

According to an embodiment of the present invention, the reflective layer may include a shielding surface, and the shielding surface is not less than the light-emitting top surface of the LED die or not less than the top surface of the light-transmissive encapsulant. The shielding surface may be of a circular shape, an elliptical shape or a polygonal shape. Moreover, the shielding surface may comprise a plurality of light-transmissive regions.

According to an embodiment of the present invention, the light device may further comprise another LED die, and the light-transmissive encapsulant covers a plurality of light-emitting side surfaces and a light-emitting top surface of the another LED die. Moreover, the lighting device may further comprise a lead frame structure or a carrier substrate, the LED die is disposed on the lead frame structure or the carrier substrate and is electrically connected with the lead frame structure or the carrier substrate, while the light-transmissive encapsulant and the light-transmissive wall are disposed on the lead frame structure.

To achieve the aforesaid objective, a lighting module disclosed by the present invention comprises: a circuit substrate and a plurality of lighting devices as described above, and the lighting devices are disposed on the circuit substrate and electrically connected with the circuit substrate.

According to an embodiment of the present invention, the lighting module may further comprise a light diffuser plate, and the light diffuser plate is disposed above the lighting devices.

According to an embodiment of the present invention, in a normal direction of the light-emitting top surface of the LED die of the lighting device, there is a vertical distance between the light diffuser plate and the circuit substrate, and in a lateral direction that is orthogonal to the normal direction, there is a lateral distance between the lighting devices; and a ratio of the vertical distance to the lateral distance may range from 0.1 to 0.8.

Accordingly, the lighting device and the lighting module of the present invention at least may provide the following benefits:
1. As the refractive index of the light-transmissive encapsulant is not greater than the refractive index of the light-transmissive wall, the light generated from the LED die will be deflected towards the lateral direction when they are transmitted into the light-transmissive wall from the light-transmissive encapsulant. In this way, the light may be spread laterally, thereby increasing the viewing angle.
2. When the light-transmissive encapsulant includes the lens, the light propagating in the normal direction can be diffused by the lens to further increase the viewing angle.
3. When the reflective layer is disposed above the LED die, the light propagating in the normal direction may be blocked by the reflective layer and then propagate towards the lateral direction to further increase the viewing angle.
4. The process of the light-transmissive wall and the light-transmissive encapsulant may follow the process of the existing reflector-cup package without using special processes, and thus the light-transmissive wall and the light-transmissive encapsulant can have a lower manufacturing cost.
5. Since the lighting devices have larger viewing angles, the lighting module required can be formed with a smaller number of lighting devices. Alternatively, the optical distance (the light-mixing distance) required by these lighting devices can be reduced so that the thickness of the lighting module can also be reduced.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1A** and **FIG. 1B** are a cross-sectional view and a perspective view of a lighting device according to a preferred embodiment of the present invention;
**FIG. 2A** and **FIG. 2B** are perspective views of a lighting device according to a preferred embodiment of the present invention;
**FIG. 3A** and **FIG. 3B** are side views of a lighting device according to a preferred embodiment of the present invention;
**FIG. 4** to **FIG. 6** are cross-sectional views of a lighting device according to a preferred embodiment of the present invention;
**FIG. 7A** is a side view of a lighting device according to a preferred embodiment of the present invention;
**FIG. 7B** and **FIG. 8A** are perspective views of a lighting device according to a preferred embodiment of the present invention;
**FIG. 8B** to **FIG. 8E** and **FIG. 8K** are cross-sectional views and a side view of a lighting device according to a preferred embodiment of the present invention;
**FIG. 8F** to **FIG. 8J** are perspective views of a lighting device according to a preferred embodiment of the present invention;
**FIG. 9A** and **FIG. 9B** are front views of a lighting module according to a preferred embodiment of the present invention;
**FIG. 9C** and **FIG. 9D** are top views of a lighting module according to a preferred embodiment of the present invention;
**FIG. 10A** to **FIG. 14C** are radiation-pattern views (views regarding distribution of angle vs. relative strength) of a lighting device according to a preferred embodiment of the present invention;
**FIG. 15A** shows light-mixing effects of a conventional lighting module at different optical distances;
**FIG. 15B** shows light-mixing effects of a lighting module according to a preferred embodiment of the present invention at different optical distances;
**FIG. 16A** and **FIG. 16B** show light-spot shapes of a conventional lighting device; and
**FIG. 16C** and **FIG. 16D** show light-spot shapes of a lighting device according to a preferred embodiment of the present invention.

### DESCRIPTION OF THE PREFERRED EMBODIMENT

In the following description, specific embodiments of the present invention will be described specifically. However, the present invention may be implemented by embodiments of different forms, and the scope claimed by the present invention should not be explained as being limited to the embodiments. As shall be appreciated by those of ordinary skill in the art, the technical content recorded in the embodiments may be modified, or substance replacement may be made to part or all of the technical features; and such modification or replacement does not depart from the claims of the patent invention.

Additionally, the technical contents of the above summary can also serve as the technical contents of the embodiments, or as possible modification of the embodiments. In addition, the directions mentioned (such as forward, back, up, down, two sides, internal and external or the like) are relative ones, and may be defined according to the usage status of the lighting device or module rather than suggesting or indicating that the lighting device or module should have a specific direction, be constructed or operated by a specific direction; and therefore, the directions should not be construed as a limitation of the present invention.

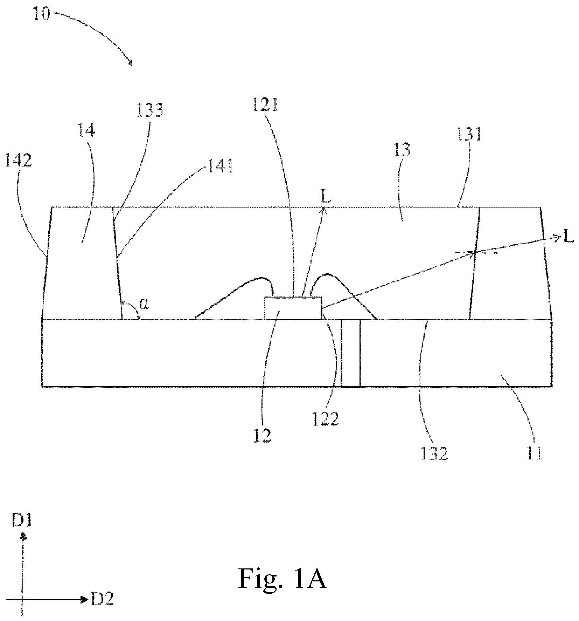

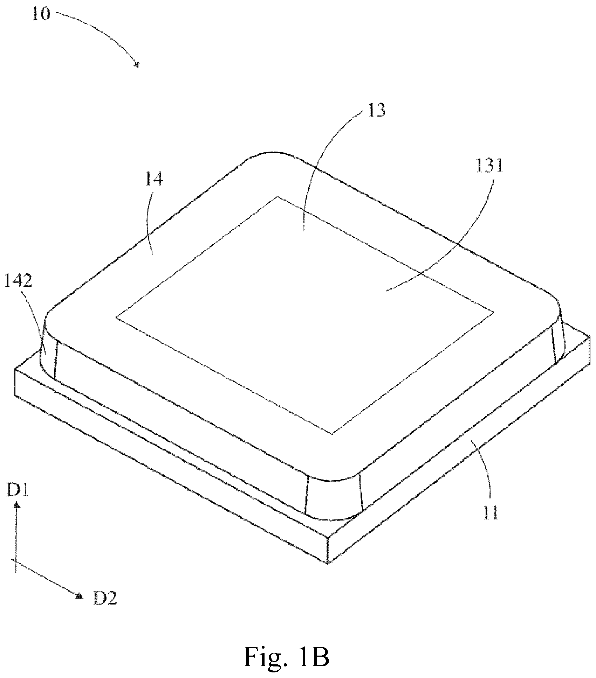

Please refer to **FIG. 1A** and **FIG. 1B****,** which are a cross-sectional view and a perspective view of a lighting device **10** according to a preferred embodiment of the present invention. The lighting device **10** may serve as a source of light for illumination, instruction, vehicle use, back light or display, to provide light irradiation at a broad angle (broad range). The lighting device **10** may include a lead frame structure **11,** an LED die **12,** a light-transmissive encapsulant **13** and a light-transmissive wall **14,** and technical contents of the elements are explained in sequence as follows.

The lead frame structure **11** comprises at least two conductive frames separated from each other, may have a shape of plate, may have some grooves or through-holes or the like, and is usually made of a metal material, a metal alloy or a metal-plated layer of a good conductivity. The LED die **12** may be a horizontal LED die, a vertical LED die, a flip-chip LED die, a high-voltage LED die or an AC serial-parallel die, and a horizontal LED die is taken as an example of this embodiment. In appearance, the LED die **12** comprises a light-emitting top surface **121** and a plurality of light-emitting side surfaces **122,** and the light-emitting top surface **121** is connected with the light-emitting side surfaces **122.** That is, the light-emitting side surfaces **122** are respectively connected to at least one side of the light-emitting top surface **121,** e.g., four sides (if the light-emitting top surface **121** is of a rectangular shape, then there are four light-emitting side surfaces **122).** The light-emitting top surface **121** is defined with a normal direction **D1** and a lateral direction **D2** that is perpendicular to the normal direction **D1,** and the light-emitting side surface **122** may be perpendicular to the lateral direction **D2.** The light **L** emitted from the semiconductor material within the LED die **12** may be emitted from the light-emitting top surface **121** and the light-emitting side surfaces **122,** and the LED die **12** has a configuration of multiple-surface emitting, e.g., a configuration of 5-surface emitting.

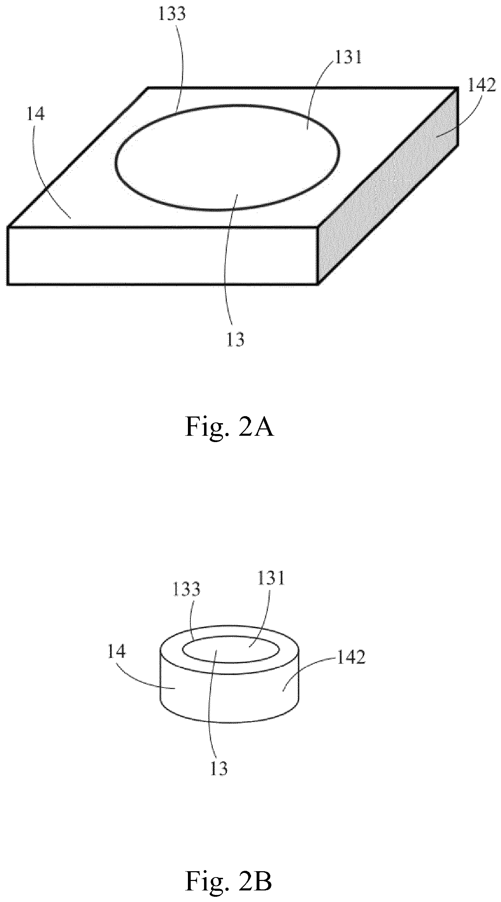

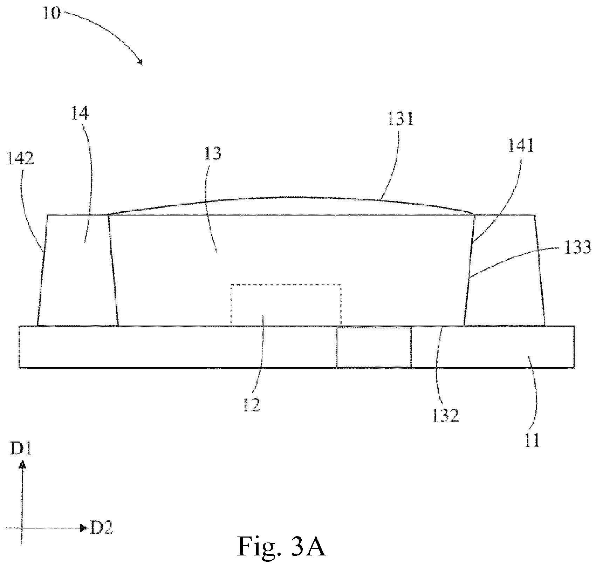

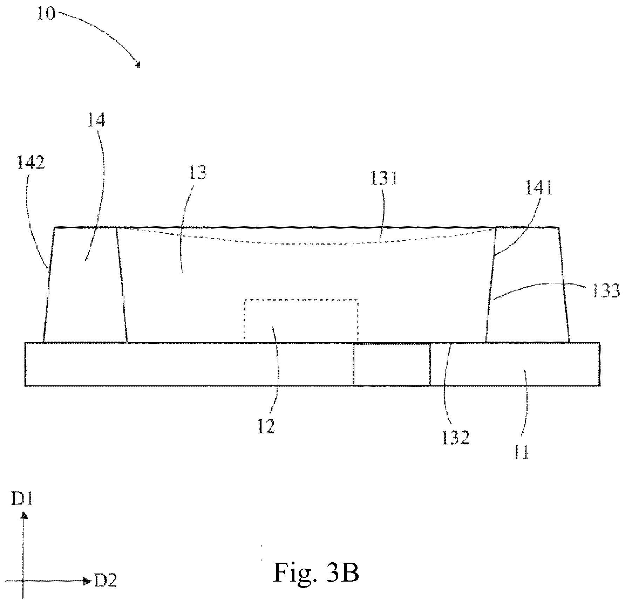

The LED die **12** is disposed on the lead frame structure **11,** and the LED die **12** is electrically connected with the lead frame structure **11** (the first and second electrodes of the LED die **12** may be respectively connected with the first and second conductive supports of the lead frame structure **11,** e.g., electrically connected by wire bonding). The light-transmissive encapsulant **13** and the lead frame structure **11** are used together to package and protect the LED die **12,** thereby avoiding or reducing the contact of the LED die **12** or other elements with moisture or the like in the environment. Therefore, the light-transmissive encapsulant **13** is disposed and formed on the lead frame structure **11,** and covers the light-emitting top surface **121** and the light-emitting side surfaces **122** of the LED die **12.** The light-transmissive encapsulant **13** may directly contact with the light-emitting top surface **121** and the light-emitting side surfaces **122.** In appearance, the light-transmissive encapsulant **13** comprises a top surface **131,** a bottom surface **132** and a plurality of side surfaces **133.** In the normal direction **D1,** the top surface **131** is parallel with the bottom surface **132** and is also parallel with the light-emitting top surface **121,** and the side surfaces **133** are connected with the top surface **131** and the bottom surface **132** along edges of the top surface **131** and the bottom surface **132.** If the top surface **131** and the bottom surface **132** are of a rectangular shape (as shown in **FIG. 1B****),** then the side surface **133** may be a flat surface; if the top surface **131** or the bottom surface **132** is of a circular or elliptical shape (as shown in **FIG. 2A** or **FIG. 2B****),** then the side surface **133** is a curve surface, and in this aspect, there is one side surface **133.** Additionally, the top surface **131** may be a flat surface, a convex surface (as shown in **FIG. 3A****)** or a concave surface (as shown in **FIG. 3B****).**

Moreover, the top surface **131** is larger than or equal to the bottom surface **132** so that the side surface **133** is vertical or inclined relative to the bottom surface **132.** In other words, an angle **α** is defined between the side surface **133** and the bottom surface **132,** and the angle **α** may range from 90 degrees to 160 degrees. The angle **α** is mainly related to the viewing angle to be described later.

The light-transmissive wall **14** is also disposed and formed above the lead frame structure **11** to make the light **L** deflect towards the lateral direction **D2.** The light-transmissive wall **14** surrounds the light-transmissive encapsulant **13** and further covers the side surface **133** of the light-transmissive encapsulant **13.** Additionally, the light-transmissive encapsulant **13** and the light-transmissive wall **14** may partially cover the lead frame structure **11** to increase the connection with the lead frame structure **11.** In the process, the light-transmissive wall **14** may first be cured and formed on the lead frame structure **11** to form a groove, then steps of die bonding and wire bonding of the LED die **12** are performed within the groove, and next the light-transmissive encapsulant **13** is formed within the groove surrounded by the light-transmissive wall **14** to cover the LED die and the wire bonding. Therefore, an inclined internal side surface **141** of the light-transmissive wall **14** corresponds to the side surface **133** of the light-transmissive encapsulant **13.** An external side surface **142** of the light-transmissive wall **14** may be an inclined or vertical flat surface (as shown in **FIG. 1A** or **FIG. 2A****)** or a curve surface (as shown in **FIG. 2B****),** i.e., the light-transmissive wall **14** is a circular body. Additionally, if the top surface **131** of the light-transmissive encapsulant **13** is a convex surface (as shown in **FIG. 3A****),** then the top surface **131** may be higher than the top surface of the light-transmissive wall **14** by 0.1 mm to 1.0 mm, and preferably be 0.2 mm to 0.7 mm.

The overall refractive index (n1) of the light-transmissive encapsulant **13** is not greater than the overall refractive index (n2) of the light-transmissive wall **14,** i.e., n1 is less than or equal to n2 (n1≤n2). As a result, according to the refractive law, the light **L** will be deflected towards the normal of the interface when the light **L** is transmitted into the light-transmissive wall **14** from the light-transmissive encapsulant **13** so that more of the light **L** will propagate towards the lateral direction **D2.** As a result, the light **L** that is emitted from the lighting device **10** in the normal direction **D1** will become less, and the light **L** that is emitted from the lighting device **10** in the lateral direction **D2** will become more. If the viewing angle is defined with Full Width at Half Maximum (FWHM) of the radiation pattern, then the light device **10** may have a larger viewing angle as compared to the case with no light-transmissive wall **14** (or where the refractive index of the light-transmissive wall **14** is less than the refractive index of the light-transmissive encapsulant **13).**

Preferably, the refractive index n1 is less than the refractive index n2, e.g., the refractive index n1 is 1.4 to 1.5, and the refractive index n2 is 1.4 to 1.6. More preferably, the refractive index n1 is 1.45, and the refractive index n2 is 1.55 so that the diffusing effect of the light **L** is better. The light-transmissive encapsulant **13** and/or the light-transmissive wall **14** may be made of a thermoplastic resin or a thermosetting resin, e.g., Phenylpropanolamine (PPA), Polycyclohexylenedimethylene terephthalate (PCT), Sheet moulding compound (SMC), Epoxy Molding Compound (EMC), Unsaturated Polyester (UP), Polycarbonate (PC), polyethylene (PE), polyethylene terephthalate (PET), Cyclic olefin copolymers (COC) or the like.

Preferably, the height of the light-transmissive wall **14** may be the same as the height of the light-transmissive encapsulant **13,** or the height of the light-transmissive wall **14** is slightly greater than the height of the light-transmissive encapsulant **13** so that the light-transmissive wall **14** completely covers the side surface **133** of the light-transmissive encapsulant **13** and the light **L** passing through each place of the side surface **133** will be deflected towards the lateral side **D2.** Due to variable or variance of the process, the light-transmissive wall **14** that is slightly higher may cover the periphery of the top surface **131** of the light-transmissive encapsulant **13.** Moreover, the viewing angle may also be increased if the light-transmissive wall **14** only covers the lower part of the side surface **133** (not shown). In addition to adjusting the viewing angle by the difference in refractive indexes between the light-transmissive wall **14** and the light-transmissive encapsulant **13** or the inclining angle, the viewing angle can also be adjusted when the top surface **131** of the light-transmissive encapsulant **13** is a convex surface or a concave surface (as shown in **FIG. 3A** and **FIG. 3B****).** In other words, the top surface **131** of the light-transmissive encapsulant **13** may form a concave lens or a convex lens, i.e., the light-transmissive encapsulant **13** comprises a lens that is formed integrally with other parts. Moreover, the top surface **131** of the light-transmissive encapsulant **13** may also be textured so that the light **L** is deflected to increase the viewing angle. In an embodiment, the light-transmissive wall **14** may be slightly lower than the light-transmissive encapsulant **13,** thereby achieving the effect of increasing the viewing angle.

Other preferred embodiments of the present invention will be described hereinafter, the same parts in the technical contents of the embodiments will be omitted or simplified from the description, and different parts shall be applied to other embodiments (unless there is obvious conflict or incompatibility in the technology).

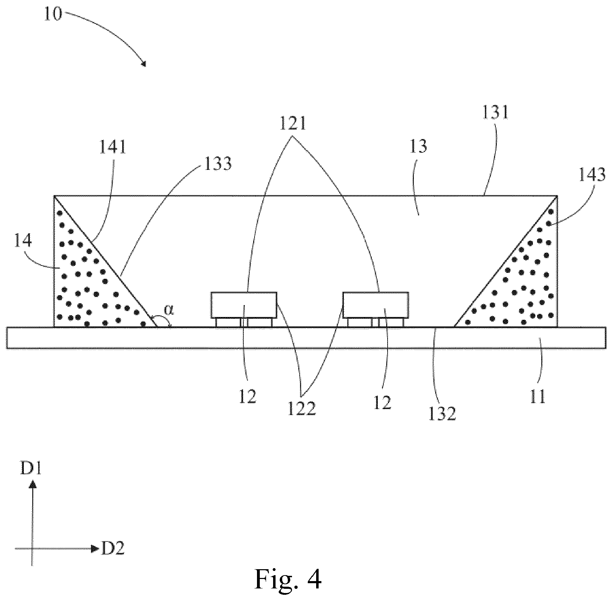

In an embodiment shown in **FIG. 4****,** the lighting device **10** comprises another LED die **12,** i.e., the lighting device **10** comprises a plurality of LED dies **12.** The another LED die **12** is disposed on the lead frame structure **11,** and the light-emitting top surface **121** and the light-emitting side surface **122** thereof are also covered by the light-transmissive encapsulant **13.** The light-emitting strength of the lighting device **10** may be larger by comprising more LED dies **12.** Additionally, these LED dies **12** are flip-chip dies, and they may also be horizontal LED dies, vertical LED dies, high-voltage LED dies or AC serial/parallel dies.

Moreover, in order to increase the structural strength of the light-transmissive wall **14,** the light-transmissive wall **14** may further comprise a filling material **143** which is mixed in the resin material of the light-transmissive wall **14.** The filling material **143** may be transparent or semi-transparent, and may also be powder, ball or the like that have tiny particle sizes, so the filling material **143** will not block the light from passing therethrough (will not make the light-transmissive wall **14** a reflective wall). The filling material **143** may also be a glass fiber or oxide (e.g., SiO₂ or TiO₂) or the like. The filling material **143** may also be used to adjust the overall refractive index of the light-transmissive wall **14.**

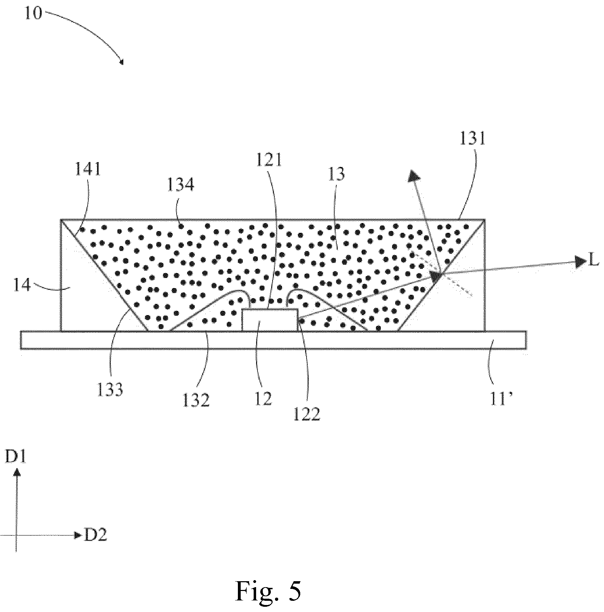

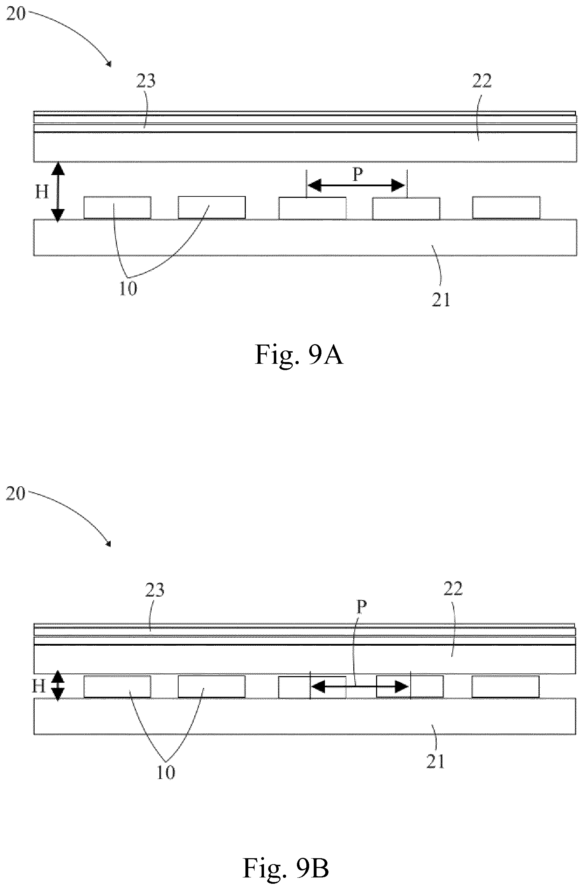

In an embodiment shown in **FIG. 5****,** the lighting device **10** comprises a carrier substrate **11'** to replace the lead frame structure **11** of the above embodiments. More specifically, the carrier substrate **11'** is a substrate made of plastic, ceramic or metal, and it has an insulation layer and a circuit layer formed thereon (not shown). The LED die **12,** the light-transmissive encapsulant **13** and the light-transmissive wall **14** may be disposed on the carrier substrate **11',** and positive and negative electrodes of the LED die **12** are further electrically connected to the carrier substrate **11'** (the first circuit layer and the second circuit layer). Furthermore, the carrier substrate **11'** can be large enough so that an assembly of a plurality of "LED dies **12,** light-transmissive encapsulants **13** and light-transmissive walls **14"** can be formed thereon to form a lighting module similar to that later shown in **FIG. 9A** to **FIG. 9D****.** On the other hand, the light-transmissive encapsulant **13** may comprise a photoluminescence material **134,** such as paint, dye, fluorescent powder, quantum-dot fluorescent powder or the like, which is mixed in a resin material of the light-transmissive encapsulant **13.** The photoluminescence material **134** may generate a light of another wavelength (i.e. color) when it is radiated by the light **L** of the LED die **12.** If the LED die **12** is a blue-light die which can emit blue light and the photoluminescence material **134** may absorb part of the blue light and generate yellow light, the lighting device **10** can generate white light (the remaining blue light that is not absorbed by the photoluminescence material is mixed with the yellow light generated by the photoluminescence material to generate the white light). Additionally, the photoluminescence material **134** can also adjust the overall refractive index of the light-transmissive encapsulant **13.**

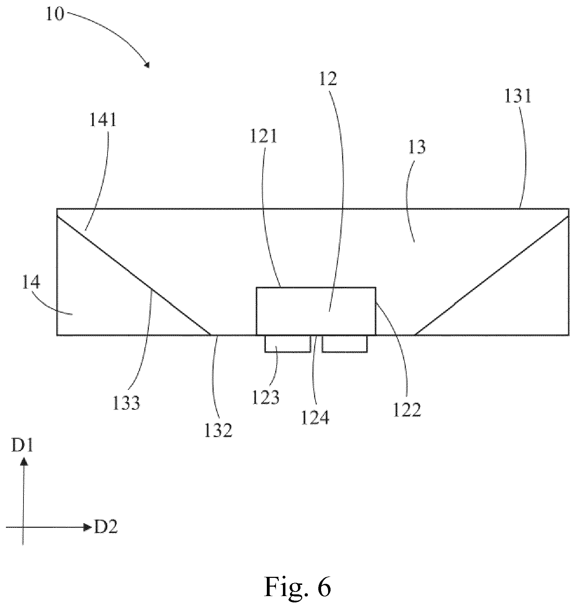

In an embodiment shown in **FIG. 6****,** the lighting device **10** may not comprise the lead frame structure **11** or the carrier substrate **11',** i.e., the lighting device **10** is a chip-scale package (CSP) without a frame or substrate. Electrodes **123** (e.g., positive and negative electrodes) of the LED die **12** within the lighting device **10** may be exposed to the outside of the light-transmissive encapsulant **13,** and the bottom surface **124** of the LED die **12** may also be exposed to the outside of the light-transmissive encapsulant **13.** The bottom surface **124** is opposite to the light-emitting top surface **121** and is connected with the light-emitting side surface **122.**

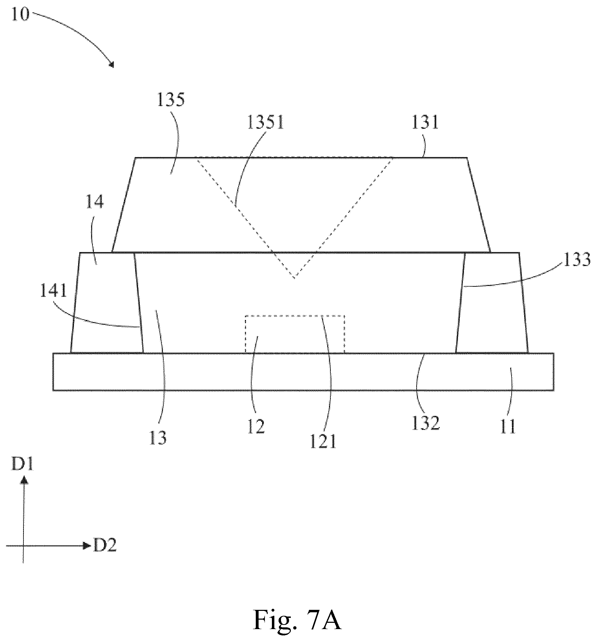

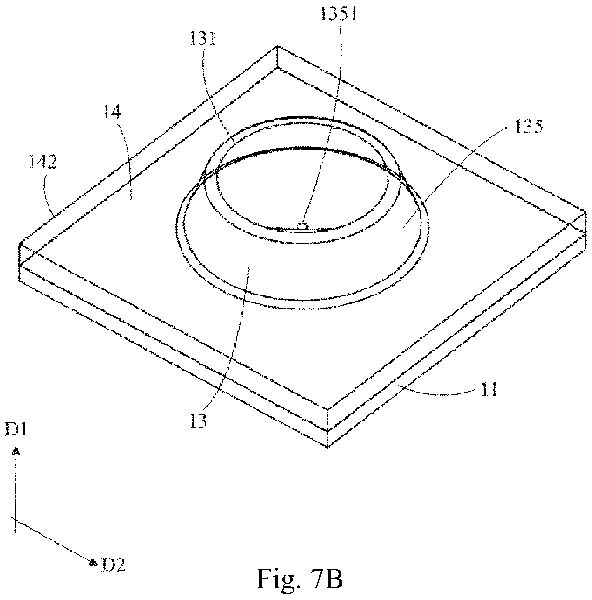

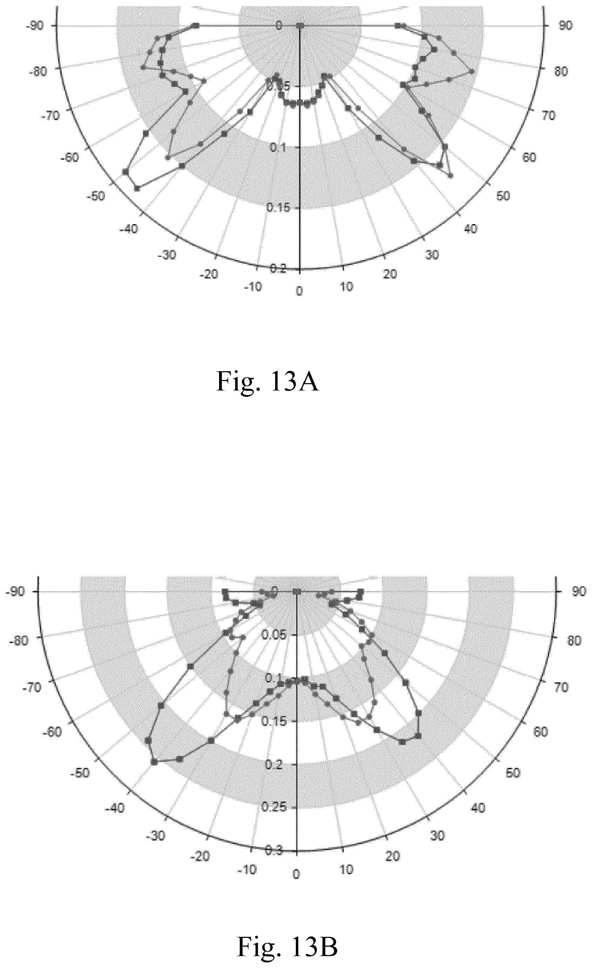

In an embodiment shown in **FIG. 7A** and **FIG. 7B****,** the light-transmissive encapsulant **13** of the lighting device **10** may comprise a lens **135,** and the lens **135** is higher than the light-transmissive wall **14,** so the lens **135** is not surrounded or shielded by the light-transmissive wall **14.** The lens **135** may optionally extend to the top surface of the light-transmissive wall **14.** The top surface **131** of the light-transmissive encapsulant **13** is the top surface of the lens **135.** The lens **135** further comprises a concave portion **1351,** and the concave portion **1351** recesses downward towards the LED die **12** from the top surface **131** to form a tapered groove. A sharp point (apex) of the concave portion **1351** may be located on an optical axis of the lens **135,** and may correspond to a center of the light-emitting top surface **121** of the LED die **12.** Air or a material having a low refractive index (i.e., a refractive index lower than that of the light-transmissive encapsulant **13)** exists on the concave portion **1351** so that the light of the LED die **12** will be deflected towards the lateral direction **D2** when it passes through the concave portion **1351** and then emitted to the outside of the lens **135,** thereby reducing the light emission in the normal direction **D1.** Accordingly, the lighting device **10** can achieve a larger viewing angle or a special radiation pattern (as shown in **FIG. 13A** and **FIG. 13B** described later).

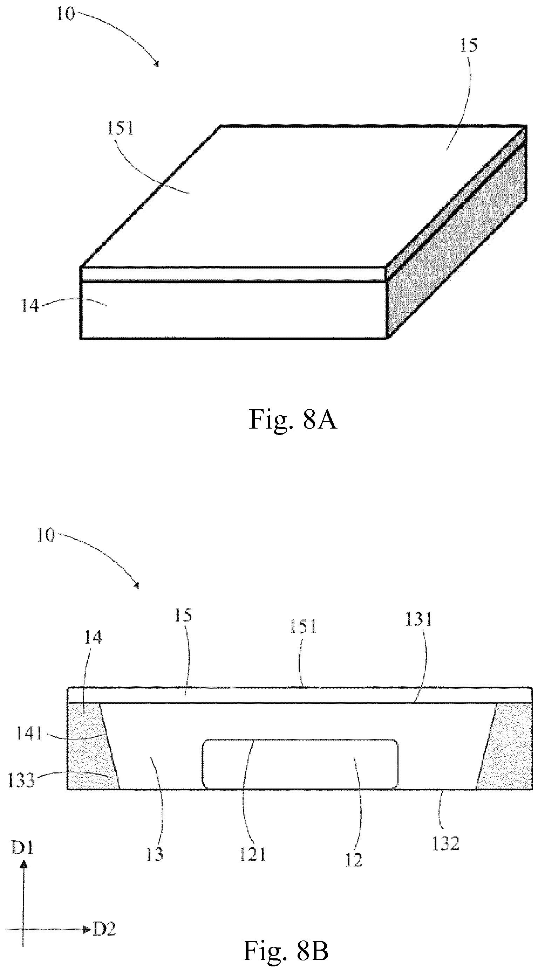

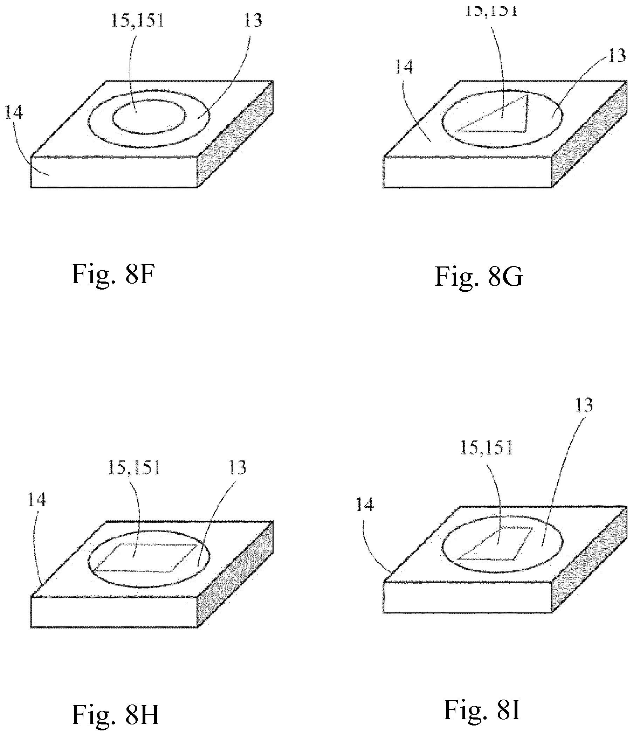

In an embodiment shown in **FIG. 8A** and **FIG. 8B****,** the lighting device **10** further comprises a reflective layer **15,** the reflective layer **15** is located above the light-emitting top surface **121** of the LED die **12** and shields the light-emitting top surface **121** in the normal direction **D1.** Similar to the concave portion **1351,** the reflective layer **15** is used to reduce the light emission in the normal direction **D1,** but the reflective layer **15** blocks the light so that the light is hard to be emitted upward. The reflective layer **15** may be formed by a metal or non-metal material, and the reflective ratio thereof for the light of the LED die **12** is preferably larger than 70%, and more preferably, is 85% to 98% (e.g., silver, aluminum or the like).

The reflective layer **15** may be directly disposed on the top surface **131** of the light-transmissive encapsulant **13,** and may be fully disposed on the top surface **131** or may be further fully disposed on the top surface of the light-transmissive wall **14.** Under such arrangement, a shielding surface **151** comprised in the reflective layer **15** is larger than or equal to (not less than) the top surface **131** of the light-transmissive encapsulant **13** so that all (or most) of the light in the normal direction **D1** is reflected by the reflective layer **15** and emitted from the external side surface **142** of the light-transmissive wall **14.**

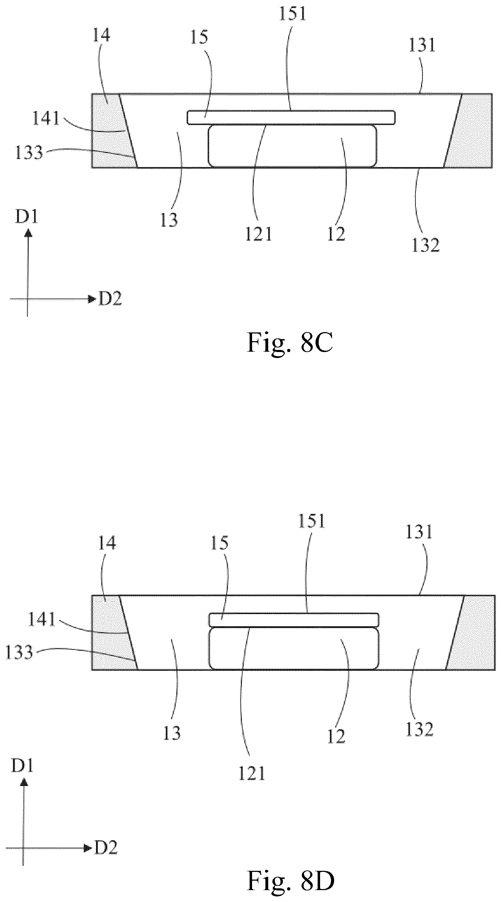

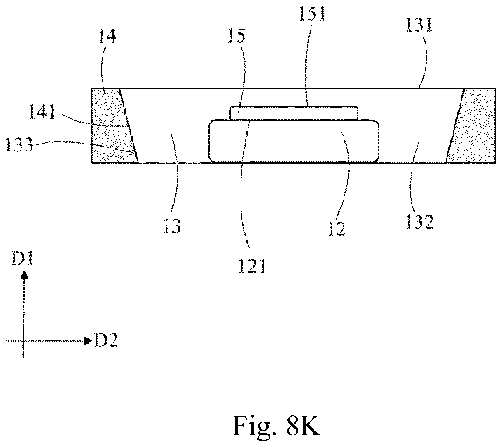

As shown in **FIG. 8C** and **FIG. 8D****,** the reflective layer **15** may also be directly disposed on the light-emitting top surface **121** of the LED die **12,** and the shielding surface **151** thereof is larger than or equal to the light-emitting top surface **121.** In this way, the light can only be emitted to the light-transmissive encapsulant **13** from the light-emitting side surface **122** of the LED die **12.** Then, part of the light emitted from the light-emitting side surface **122** might still be emitted from the top surface **131** of the light-transmissive encapsulant **13.** As shown in **FIG. 8K****,** the shielding surface **151** of the reflective layer **15** may also be less than the light-emitting top surface **121,** so the light may still be emitted from the part of the light-emitting top surface **121** that is not shielded.

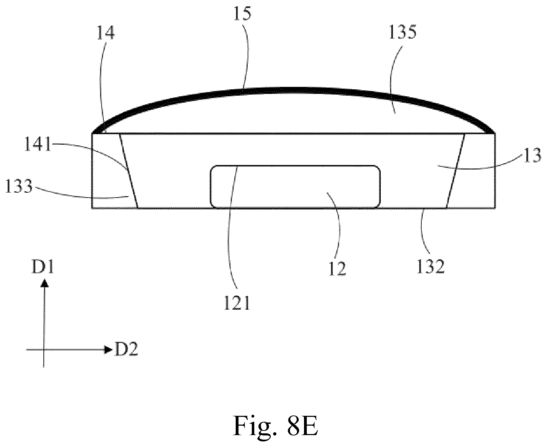

In the process, the reflective layer **15** is first formed on the LED die **12,** and then the light-transmissive encapsulant **13** is formed to cover the reflective layer **15** and the LED die **12,** and the light-transmissive encapsulant **13** does not directly contact with the light-emitting top surface **121** of the LED die **12.** Further as shown in **FIG. 8E****,** if the light-transmissive encapsulant **13** comprises a lens **135,** then the reflective layer **15** may be disposed on the lens **135** in a domed form. On the other hand, relative to the light-transmissive encapsulant **13** or the LED die **12,** the thickness of the reflective layer **15** is smaller, so the reflective layer **15** is in the form of a film or foil. The reflective layer **15** may also be directly formed on the light-transmissive encapsulant **13** or the LED die **12** via adhesive-dispensing, printing or spraying processes or the like. For example, a non-metal material (boron nitride (BN), titanium dioxide (TiO₂), silicon dioxide (SiO₂)) or a metal material (a scattering or reflective material) is mixed into a resin and then formed on the light-transmissive encapsulant **13** or the LED die **12** via the above process, and the reflective layer **15** is formed after the resin is cured.

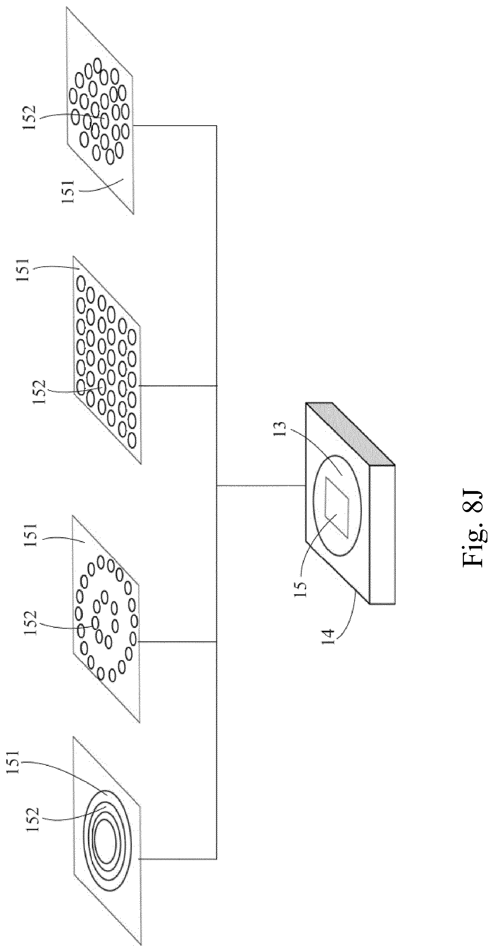

As shown in **FIG. 8F to FIG. 8I****,** the shielding surface **151** of the reflective layer **15** may be of a circular shape, an elliptical shape or a polygonal (triangular, rectangular, trapezoid, etc.) shape, and may be less than the top surface **131** of the light-transmissive encapsulant **13.** In addition, as shown in **FIG. 8J****,** the shielding surface **151** may comprise a plurality of light-transmissive regions **152,** and the light-transmissive regions **152** may be of a ring shape or a round-hole shape and may be arranged in a variety of manners. The light can pass through the light-transmissive regions **152** and will not be reflected.

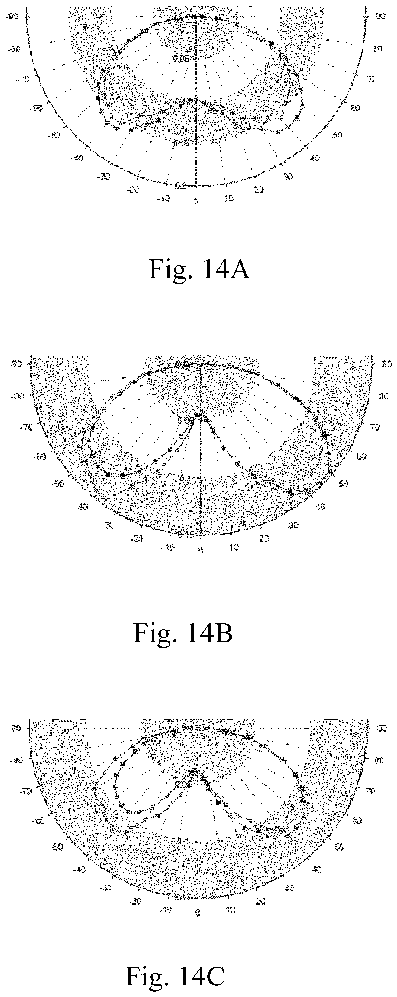

Through the reflective layer **15,** the lighting device **10** can have a larger viewing angle or a special radiation pattern (as shown in **FIG. 14A to FIG. 14C** described later), and different viewing angles or radiation patterns can be obtained by adjusting design parameters such as the size, position, shape and light-transmissive region **152** or the like of the shielding surface **151** of the reflective layer **15.**

Referring to **FIG. 9A** to **FIG. 9D****,** in another preferred embodiment of the present invention, a lighting module **20** is provided, the lighting module **20** comprises a circuit substrate **21** and a plurality of lighting devices **10,** and the lighting devices **10** are disposed on the circuit substrate **21** and electrically connected with the circuit substrate **21.** Specifically, the circuit substrate **21** is similar to the carrier substrate **11'** shown in **FIG. 4****,** but the circuit substrate **21** has a larger size and the driving circuit thereof can individually light up the lighting devices **10,** and the lighting devices **10** may be any lighting device in the above embodiments.

If the lighting module **20** is used as the back-light source of the display, then an light diffuser plate **22** may be further included, and the light diffuser plate **22** is located above the lighting devices **10** so that the light of the lighting device **10** is further diffused and the light is uniformly irradiated on the display panel. Additionally, one or more optical elements **23,** e.g., a prism sheet, a dual brightness enhancement film (DBEF) or the like, may be further disposed on the light diffuser plate **22** depending on the situation of application.

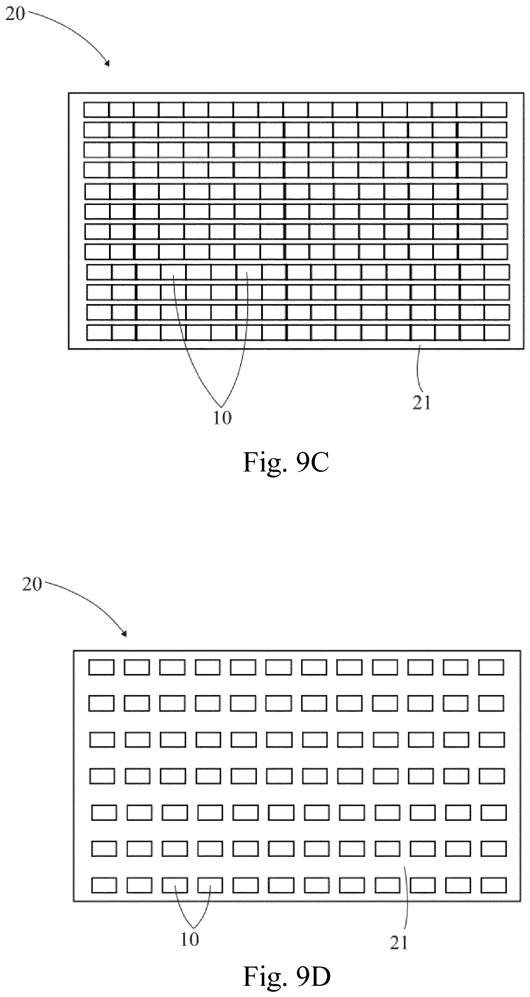

In the normal direction **D1,** there is a vertical distance **H** between the bottom surface of the light diffuser plate **22** and the top surface of the circuit substrate **21,** and in the lateral direction **D2,** there is a lateral distance **P** between the lighting devices **10,** and the lateral distance **P** is a line distance between centers of two adjacent lighting devices **10.** The vertical distance **H** corresponds to the optical distance (OD) required for the light mixing, and the lateral distance **P** corresponds to the density of the lighting devices **10.** Because the lighting device **10** can have a larger viewing angle, the vertical distance **H** may be smaller and the lateral distance **P** may be larger. Comparing those shown in **FIG. 9A** and **FIG. 9B****,** when the vertical distance **H** is reduced, the overall thickness of the lighting module **20** can also be reduced; and comparing those shown in **FIG. 9C** and **FIG. 9D****,** when the lateral distance **P** is increased, the number of the lighting devices **10** required by the light module **20** can also be reduced.

The ratio of the vertical distance **H** to the lateral distance **P** (H/P) may range from 0.1 to 0.8, which is superior to the ratio of the conventional lighting device (the H/P thereof is usually larger than 1.0). In other words, the lighting module **20** may be thinner or have fewer number of lighting devices **10** as compared to the conventional lighting module, thereby achieving the same light-mixing requirements.

As can be known from the following table showing a measurement result of viewing angles of various types of lighting devices, the light-transmissive wall can increase the viewing angle of the lighting device to be more than 150 degrees, and the arrangement of the reflective layer further increases the viewing angle to be more than 160 degrees. Because the viewing angle is increased to be more than 150 degrees, the ratio of the vertical distance **H** to the lateral distance **P** of the lighting module (H/P) is reduced to 0.47 or 0.31.

| Types | Without reflective layer | Light-emitting top surface being larger than the shielding surface | Light-emitting top surface being equal to the shielding surface | Light-emitting top surface being smaller than the shielding surface | Top surface of the light-transmissive encapsulant and the light-transmissive wall being equal to the shielding surface |
|---|---|---|---|---|---|
| Angle (X-axis/Y-axis) | 150.9/ 158.4 | 155.9/ 160.3 | 164.5/ 164.9 | 166.5/ 164.9 | 180/ 180 |
| H/P | 0.47 | 0.31 | | | |

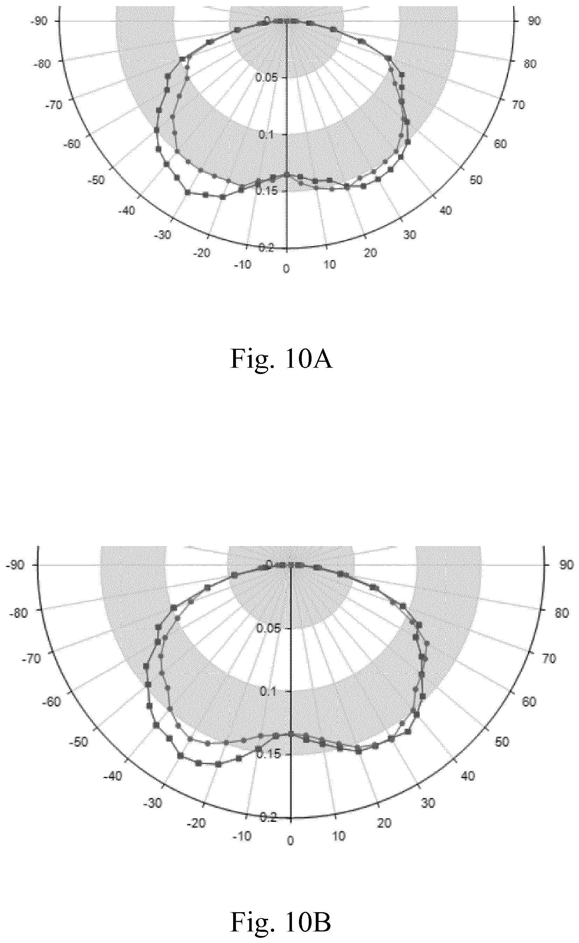

Through the simulation of the software, viewing angles and radiation patterns of various types of lighting devices can also be appreciated. Because the LED die used for simulation and the LED die used for the above measurement are of different types, the viewing angles derived from the above LED dies are not exactly the same. Referring to **FIG. 10A** and **FIG. 10B****,** the following parameters are used for simulation: the size of the lead frame structure is 3 mm × 3 mm × 0.25 mm; the thickness of the light-transmissive encapsulant and the light-transmissive wall is 0.55 mm; the refractive index of the light-transmissive encapsulant is 1.4 to 1.5, the refractive index of the light-transmissive wall is 1.4 to 1.6; and the top surface of the light-transmissive encapsulant is a flat surface (similar to the lighting device of **FIG. 1A****).** When the lighting device has a single LED die (single-die), the viewing angle thereof (X-axis/Y-axis) is 142/144 degrees, and the radiation pattern is as shown in **FIG. 10A****.** When the lighting device has two LED dies (double-die), the viewing angle thereof (X-axis/Y-axis) is 143/142 degrees, and the radiation pattern is as shown in **FIG. 10B****.**

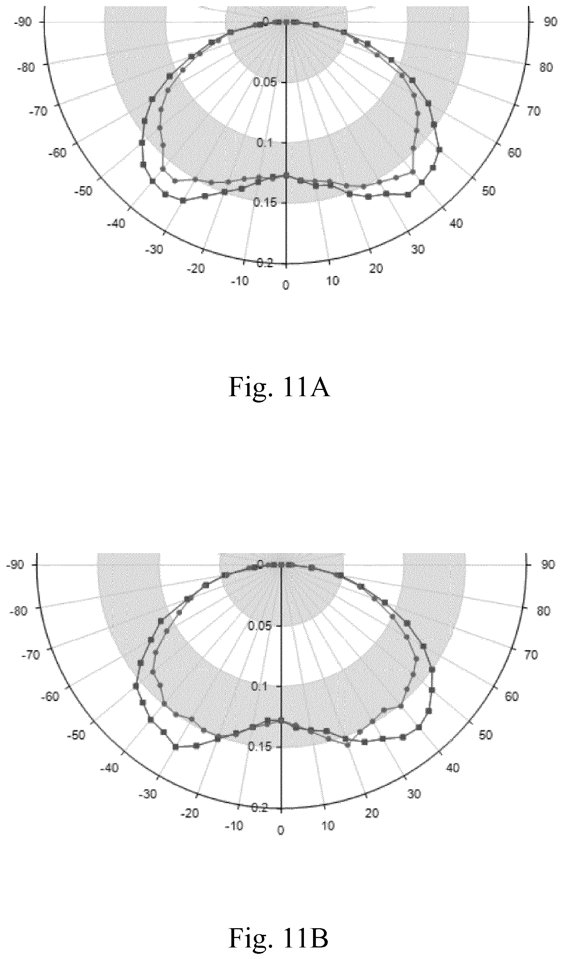

If the thickness of the light-transmissive encapsulant and the light-transmissive wall is reduced to 0.35 mm, and the remaining parameters are as described above, the viewing angle (X-axis/Y-axis) of the single-die case is 139/138 degrees, and the radiation pattern is as shown in **FIG. 11A****;** the viewing angle (X-axis/Y-axis) of the double-die case is 138/139 degrees, and the radiation pattern is as shown in **FIG. 11B****.** As can be known from the above description, the radiation pattern is closer to batwing when the thickness of the light-transmissive encapsulant is reduced.

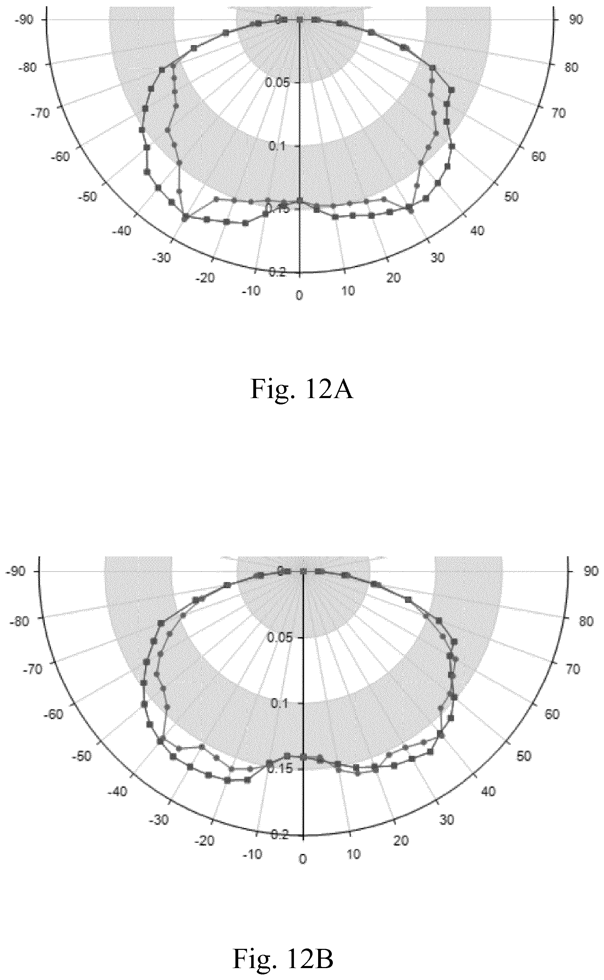

If the top surface of the light-transmissive encapsulant is a convex surface (similar to the lighting device of **FIG. 3A****),** the thickness of the light-transmissive encapsulant is 0.6 mm, the thickness of the light-transmissive wall is 0.55 mm, and the remaining parameters are as described above, the viewing angle (X-axis/Y-axis) of the single-die case is 148/144 degrees, and the radiation pattern is as shown in **FIG. 12A****;** the viewing angle (X-axis/Y-axis) of the double-die case is 149/147 degrees, and the radiation pattern is as shown in **FIG. 12B****.**

If the light-transmissive encapsulant has a lens and a concave portion (similar to the lighting device of **FIG. 7A****),** the thickness of the light-transmissive encapsulant is 0.99 mm, the thickness of the light-transmissive wall is 0.55 mm, and the remaining parameters are as described above, then the viewing angle (X-axis/Y-axis) of the single-die case is 175/177 degrees, and the radiation pattern is as shown in **FIG. 13A****;** the viewing angle (X-axis/Y-axis) of the double-die case is 130/127 degrees, and the radiation pattern is as shown in **FIG. 13B****.** The radiation pattern is closest to batwing. It shall be additionally appreciated that, in the single-die case, the sharp point of the concave portion may correspond to the center of the light-emitting top surface of the LED die, so the light of the LED die can be effectively diffused outward by the concave portion. In the dual-die case, the sharp point of the concave portion corresponds to a gap between two dies, so the light of the LED die is diffused to a smaller degree, but the angle of the light after being diffused is still larger than the original light angle (increased by about 128 degrees).

If there is a reflective layer, the thickness of the light-transmissive encapsulant and the light-transmissive wall is 0.6 mm, the top surface of the light-transmissive encapsulant is a flat surface (similar to the lighting device of **FIG. 8A****),** and the remaining parameters are as described above, then the viewing angle (X-axis/Y-axis) of the case where the shielding surface is 0.205 × 0.125 mm is 138/144 degrees, and the radiation pattern is as shown in **FIG. 14A****;** the viewing angle (X-axis/Y-axis) of the case where the shielding surface is 0.41 × 0.25 mm is 145/144 degrees, and the radiation pattern is as shown in **FIG. 14B****;** the viewing angle (X-axis/Y-axis) of the case where the shielding surface is 0.82 × 0.5 mm is 144/150 degrees, and the radiation pattern is as shown in **FIG. 14C****.** As can be known from the above description, if the reflective layer has a larger shielding surface, then the viewing angle is larger, and the radiation pattern is closer to batwing.

A measurement result of viewing angles of various types of lighting devices is summarized in the following table.

| Corresponding Figure | Viewing angle (X-axis /Y-axis) | Notes |
|---|---|---|
| FIG. 10A | 142/144 | Single-die, the top surface being a flat surface |
| FIG. 10B | 143/142 | Double-die, the top surface being a flat surface |
| FIG. 11A | 139/138 | Single-die, the top surface being a flat surface, thickness being reduced |
| FIG. 11B | 138/139 | Double-die, the top surface being a flat surface, thickness being reduced |
| FIG. 12A | 148/144 | Single-die, the top surface being a convex surface |
| FIG. 12B | 149/147 | Double-die, the top surface being a convex surface |
| FIG. 13A | 175/177 | Single-die, having a lens and a concave portion |
| FIG. 13B | 130/127 | Double-die, having a lens and a concave portion |
| FIG. 14A | 138/144 | Single-die, small shielding surface |
| FIG. 14B | 145/144 | Single-die, middle shielding surface |
| FIG. 14C | 144/150 | Single-die, large shielding surface |

The viewing angle describe above is defined according to the Full Width at Half Maximum (FWHM) of the radiation pattern, taking **FIG. 10A** as an example, the maximum intensity of the radiation pattern shown is 0.17 on the X-axis, and the half value of the maximum intensity is 0.875, the maximum angle corresponding to the half value on the X-axis is about -70 degrees and 72 degrees, so the viewing angle on the X-axis may be calculated as 142 degrees. Similarly, the viewing angle on the X-axis and the Y-axis in **FIG. 10A to FIG. 14C** can be obtained.

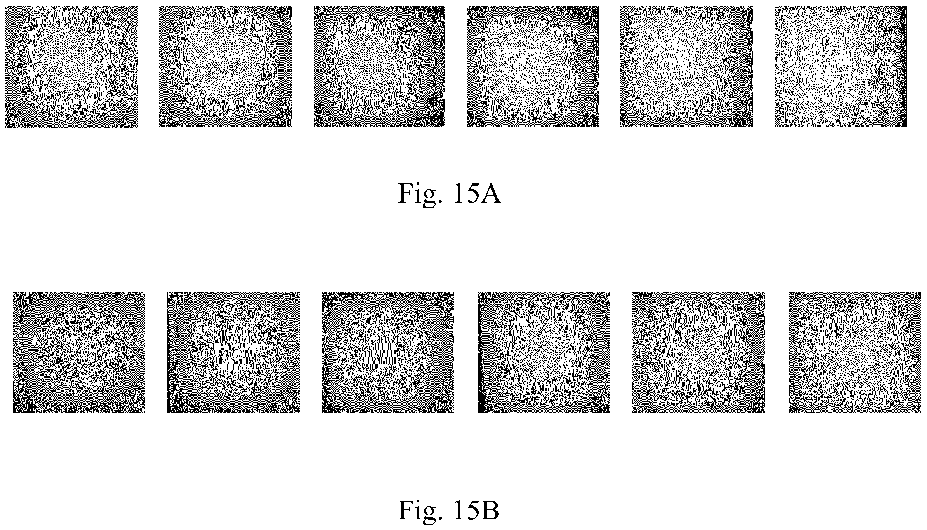

Next, referring to **FIG. 15A** and **FIG. 15B****,** the conventional lighting device and the lighting device of the present invention are all arranged on the circuit substrate with a lateral distance of 8.5 mm, and light-mixing effects at different vertical distances are tested respectively (the light-mixing effects from left to right are respectively the light-mixing effects at 10 mm, 8 mm, 6 mm, 4 mm, 3 mm and 2 mm). As shown in **FIG. 15A****,** when the vertical distance is 6 mm, the profile of the conventional lighting device is already observable, which means that the light is not mixed uniformly. As shown in **FIG. 15B****,** the profile of the lighting device of the present invention can be seen only when the vertical distance is 3 mm. As can be known from the above description, when the lighting module is constituted by the lighting devices of the present invention, a uniform light-mixing effect can be achieved with a smaller vertical distance.

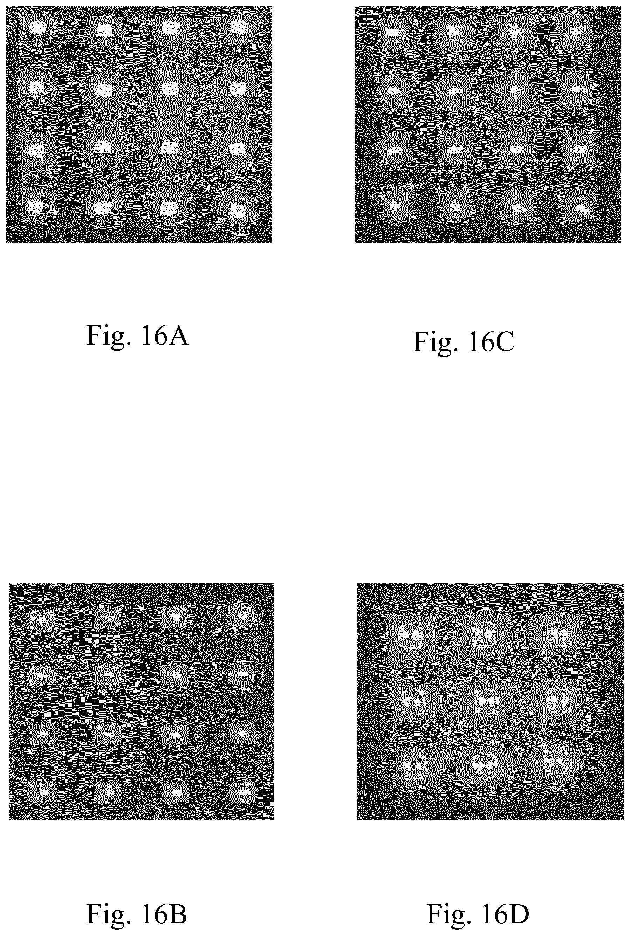

Further referring to **FIG. 16A** to **FIG. 16D****,** the shape of the light spot of the conventional lighting device corresponds to the profile of the reflector cup **(****FIG. 16A, FIG. 16B****),** and the light spot of the lighting device of the present invention has a special shape, and arrows in a radial pattern can be observed **(****FIG. 16C** and **FIG. 16D****).** As can be known from the above description, the lighting device of the present invention can also provide illumination of a special light-spot shape in addition to providing illumination of a larger viewing angle.

In an embodiment, the light emitted from the LED die may be ultraviolet (for example, UVC, UVB, UVA), blue light or blue-green light. In an embodiment, the LED die comprises an N-type semiconductor layer, an active layer and a P-type semiconductor layer, the active layer is interposed between the N-type semiconductor layer and the P-type semiconductor layer, and the active layer may be a multiple quantum-well layer. In an embodiment, the LED die can be replaced by a laser diode die, and the light emitted by the laser diode may be ultraviolet (for example, UVC, UVB, UVA), blue light or blue-green light. In an embodiment, the laser diode die comprises an N-type semiconductor layer, an active layer and a P-type semiconductor layer, the active layer is interposed between the N-type semiconductor layer and the P-type semiconductor layer, and the active layer may be a multiple quantum-well layer.

In an embodiment, the light-transmissive encapsulant may comprise a first photoluminescence material, the first photoluminescence material may absorb the light of the LED die to emit a light having a first wavelength, but the light-transmissive wall does not comprise any photoluminescence material. The concentration of the first photoluminescence material may be uniform, or the concentration of the first photoluminescence material is gradually reduced or increased in the direction from the top surface of the light-transmissive encapsulant to the top surface of the LED die.

In an embodiment, the light-transmissive wall may comprise a first photoluminescence material, the first photoluminescence material may absorb the light of the LED die to emit a light having a first wavelength, but the light-transmissive encapsulant does not comprise any photoluminescence material. The concentration of the first photoluminescence material may be uniform, or the concentration of the first photoluminescence material is gradually reduced or increased in the direction from the external side surface of the light-transmissive wall to the LED die.

In an embodiment, the light-transmissive encapsulant may comprise a first photoluminescence material and a second photoluminescence material, the first photoluminescence material may absorb the light of the LED die to emit a light having a first wavelength. The light-transmissive wall may comprise a second photoluminescence material, and the second photoluminescence material may absorb the light of the LED die to emit a light having a second wavelength. The concentration of the first photoluminescence material may be uniform, or the concentration of the first photoluminescence material is gradually reduced or increased in the direction from the top surface of the light-transmissive encapsulant to the top surface of the LED die. The concentration of the second photoluminescence material may be uniform, or the concentration of the second photoluminescence material is gradually reduced or increased in the direction from the external side surface of the light-transmissive wall to the LED die.

In an embodiment, the light-transmissive encapsulant may comprise a first photoluminescence material and a second photoluminescence material, but the light-transmissive wall does not comprise any photoluminescence material. The first photoluminescence material may be distributed above the LED die, and the second photoluminescence material may be distributed at the periphery of the side surface of the LED die. The concentration of the first photoluminescence material and the second photoluminescence material may be uniform, or the concentration of the first photoluminescence material and the second photoluminescence material is gradually reduced or increased in the direction from the top surface of the light-transmissive encapsulant to the top surface of the LED die.

In an embodiment, the light-transmissive wall may comprise a first photoluminescence material and a second photoluminescence material, but the light-transmissive encapsulant does not comprise any photoluminescence material. The concentration of the first photoluminescence material and the second photoluminescence material may be uniform, or the concentration of the first photoluminescence material and the second photoluminescence material is gradually reduced or increased in the direction from the external side surface of the light-transmissive wall to the LED die.

The first wavelength may be the same as or different from the second wavelength. The first wavelength may be less than or larger than the second wavelength. The first and second photoluminescence materials may be any combination of yellow fluorescent powder, green fluorescent powder and red fluorescent powder. The yellow fluorescent powder may be Y₃Al₅O₁₂: Ce³⁺ (called for short as YAG) and (Sr, Ba)₂SiO₄: Eu²⁺ (the content of Sr²⁺ is higher, called for short as Silicate), the green fluorescent powder may be Si_{6-z}Al_{z}O_{z}N_{8-z}:Eu²⁺ (called for short as β-SiAlON) and Lu₃Al₅O₁₂:Ce³⁺ (called for short as LuAG), the red fluorescent powder may be CaAlSiN₃:Eu²⁺ (called for short as CASN or 1113), Sr₂Si₅N₈:Eu²⁺ (called for short as 258) and K₂SiF₆:Mn⁴⁺(called for short as KSF).

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A lighting module (20), comprising: a circuit substrate (21); a plurality of lighting devices (10) disposed on the circuit substrate (21) and electrically connected with the circuit substrate (21); and a light diffuser plate (22) disposed above the lighting devices (10), each of the lighting devices (10) comprising:
an LED die (12), comprising a light-emitting top surface (121) and a plurality of light-emitting side surfaces (122), the light-emitting top surface (121) being connected with the light-emitting side surfaces (122);
a light-transmissive encapsulant (13), covering the light-emitting side surfaces (122) and the light-emitting top surface (121) of the LED die (12), and comprising a plurality of side surfaces (133) connected with each other, a top surface (131) and a bottom surface (132);
a light-transmissive wall (14), surrounding the light-transmissive encapsulant (13), covering the side surfaces (133) of the light-transmissive encapsulant (13); wherein the light-transmissive wall (14) comprises an externally exposed side surface (142), and a refractive index of the light-transmissive encapsulant (13) is less than a refractive index of the light-transmissive wall (14); and
a lead frame structure (11), wherein the LED die (12) is disposed on the lead frame structure (11) and is electrically connected with the lead frame structure (11), while the light-transmissive encapsulant (13) and the light-transmissive wall (14) are disposed on the lead frame structure (11),
wherein in the lighting module (20)
in a normal direction of the light-emitting top surface (121) of the LED die (12) of the lighting device (10), there is a vertical distance between the light diffuser plate and the circuit substrate, and in a lateral direction that is orthogonal to the normal direction, there is a lateral distance between the lighting devices (10); and a ratio of the vertical distance to the lateral distance ranges from 0.1 to 0.8.

2. The lighting module (20) of Claim 1, wherein an angle is defined between the side surface (133) and the bottom surface (132) of the light-transmissive encapsulant (13) of the light device (10), and the angle ranges from 90 degrees to 160 degrees.

3. The lighting module (20) of Claim 1, wherein the light-transmissive wall (14) comprises a filling material for increasing the structural strength.

4. The lighting module (20) of Claim 1, wherein the light-transmissive encapsulant (13) comprises a photoluminescence material.

5. The lighting module (20) of Claim 1, wherein the top surface (131) of the light-transmissive encapsulant (13) is selected from the group consisting of a flat surface, a concave surface, a convex surface and any combination thereof.

6. The lighting module (20) of Claim 1, wherein the light-transmissive encapsulant (13) further comprises a lens, and the lens comprises a concave portion.

7. The lighting module (20) of Claim 1, each of the lighting device (10) further comprising a reflective layer, wherein the reflective layer (15) is located above the light-emitting top surface (121) of the LED die (12), and shields the light-emitting top surface (121) in a normal direction of the light-emitting top surface (121).

8. The lighting module (20) of Claim 7, wherein the reflective layer (15) is disposed on the top surface (131) of the light-transmissive encapsulant (13) or disposed on the light-emitting top surface (121) of the LED die (12).

9. The lighting module (20) of Claim 7, wherein the reflective layer (15) includes a shielding surface (151), and the shielding surface (151) is not less than the light-emitting top surface (121) of the LED die (12) or not less than the top surface of the light-transmissive encapsulant (13).

10. The lighting module (20) of Claim 9, wherein the shielding surface (151) is of a circular shape, an elliptical shape or a polygonal shape.

11. The lighting module (20) of Claim 9, wherein the shielding surface (151) comprises a plurality of light-transmissive regions.

12. The lighting module (20) of Claim 1, each of the lighting device (10) further comprising another LED die (12), wherein the light-transmissive encapsulant (13) covers a plurality of light-emitting side surfaces (122) and a light-emitting top surface (121) of the another LED die (12).

13. The lighting module (20) of Claim 1, wherein any of the light-transmissive encapsulant (13) and the light-transmissive wall (14) comprises a thermoplastic resin or a thermosetting resin.

## Patentansprüche

1. Beleuchtungsmodul (20), umfassend: ein Schaltungssubstrat (21); eine Vielzahl von Beleuchtungsvorrichtungen (10), die auf dem Schaltungssubstrat (21) angeordnet und elektrisch mit dem Schaltungssubstrat (21) verbunden sind; und eine Lichtstreuplatte (22), die über den Beleuchtungsvorrichtungen (10) angeordnet ist, wobei jede der Beleuchtungsvorrichtungen (10) umfasst:
einen LED-Chip (12), umfassend eine lichtemittierende Oberseite (121) und eine Vielzahl von lichtemittierenden Seitenflächen (122), wobei die lichtemittierende Oberseite (121) mit den lichtemittierenden Seitenflächen (122) verbunden ist;
ein lichtdurchlässiges Verkapselungsmaterial (13), das die lichtemittierenden Seitenflächen (122) und die lichtemittierende Oberseite (121) des LED-Chips (12) abdeckt und eine Vielzahl von miteinander verbundenen Seitenflächen (133), eine Oberseite (131) und eine Unterseite (132) umfasst;
eine lichtdurchlässige Wand (14), die das lichtdurchlässige Verkapselungsmaterial (13) umgibt und die Seitenflächen (133) des lichtdurchlässigen Verkapselungsmaterials (13) abdeckt; wobei die lichtdurchlässige Wand (14) eine nach außen freiliegende Seitenfläche (142) aufweist und ein Brechungsindex des lichtdurchlässigen Verkapselungsmaterials (13) kleiner als ein Brechungsindex der lichtdurchlässigen Wand (14) ist; und
eine Leiterrahmenstruktur (11), wobei der LED-Chip (12) auf der Leiterrahmenstruktur (11) angeordnet ist und elektrisch mit der Leiterrahmenstruktur (11) verbunden ist, während das lichtdurchlässige Verkapselungsmaterial (13) und die lichtdurchlässige Wand (14) auf der Leiterrahmenstruktur (11) angeordnet sind,
wobei in dem Beleuchtungsmodul (20) in einer Normalenrichtung der lichtemittierenden Oberseite (121) des LED-Chips (12) der Beleuchtungsvorrichtung (10) ein vertikaler Abstand zwischen der Lichtstreuplatte und dem Schaltungssubstrat ist und in einer zu der Normalenrichtung orthogonalen seitlichen Richtung ein seitlicher Abstand zwischen den Beleuchtungsvorrichtungen (10) ist; und ein Verhältnis des vertikalen Abstandes zu dem seitlichen Abstand in dem Bereich von 0,1 bis 0,8 liegt.

2. Beleuchtungsmodul (20) nach Anspruch 1, wobei zwischen der Seitenfläche (133) und der Unterseite (132) des lichtdurchlässigen Verkapselungsmaterials (13) der Beleuchtungsvorrichtung (10) ein Winkel definiert ist, und der Winkel in dem Bereich von 90 Grad bis 160 Grad liegt.

3. Beleuchtungsmodul (20) nach Anspruch 1, wobei die lichtdurchlässige Wand (14) ein Füllmaterial zur Erhöhung der strukturellen Festigkeit umfasst.

4. Beleuchtungsmodul (20) nach Anspruch 1, wobei das lichtdurchlässige Verkapselungsmaterial (13) ein Photolumineszenzmaterial umfasst.

5. Beleuchtungsmodul (20) nach Anspruch 1, wobei die Oberseite (131) des lichtdurchlässigen Verkapselungsmaterials (13) aus der Gruppe ausgewählt ist, die aus einer ebenen Fläche, einer konkaven Fläche, einer konvexen Fläche und einer beliebigen Kombination davon besteht.

6. Beleuchtungsmodul (20) nach Anspruch 1, wobei das lichtdurchlässige Verkapselungsmaterial (13) ferner eine Linse umfasst und die Linse einen konkaven Abschnitt aufweist.

7. Beleuchtungsmodul (20) nach Anspruch 1, wobei jede der Beleuchtungsvorrichtungen (10) ferner eine reflektierende Schicht umfasst, wobei sich die reflektierende Schicht (15) über der lichtemittierenden Oberseite (121) des LED-Chips (12) befindet und die lichtemittierende Oberseite (121) in einer Normalenrichtung der lichtemittierenden Oberseite (121) abschirmt.

8. Beleuchtungsmodul (20) nach Anspruch 7, wobei die reflektierende Schicht (15) auf der Oberseite (131) des lichtdurchlässigen Verkapselungsmaterials (13) oder auf der lichtemittierenden Oberseite (121) des LED-Chips (12) angeordnet ist.

9. Beleuchtungsmodul (20) nach Anspruch 7, wobei die reflektierende Schicht (15) eine Abschirmfläche (151) umfasst und die Abschirmfläche (151) nicht kleiner als die lichtemittierende Oberseite (121) des LED-Chips (12) ist oder nicht kleiner als die Oberseite des lichtdurchlässigen Verkapselungsmaterials (13) ist.

10. Beleuchtungsmodul (20) nach Anspruch 9, wobei die Abschirmfläche (151) eine kreisförmige, eine elliptische oder eine polygonale Form aufweist.

11. Beleuchtungsmodul (20) nach Anspruch 9, wobei die Abschirmfläche (151) eine Vielzahl lichtdurchlässiger Bereiche umfasst.

12. Beleuchtungsmodul (20) nach Anspruch 1, wobei jede der Beleuchtungsvorrichtungen (10) ferner einen weiteren LED-Chip (12) umfasst, wobei das lichtdurchlässige Verkapselungsmaterial (13) eine Vielzahl von lichtemittierenden Seitenflächen (122) und eine lichtemittierende Oberseite (121) des weiteren LED-Chips (12) abdeckt.

13. Beleuchtungsmodul (20) nach Anspruch 1, wobei das lichtdurchlässige Verkapselungsmaterial (13) oder die lichtdurchlässige Wand (14) ein thermoplastisches Harz oder ein duroplastisches Harz umfasst.

## Revendications

1. Module d'éclairage (20), comprenant :
un substrat de circuit (21) ; une pluralité de dispositifs d'éclairage (10) disposés sur le substrat de circuit (21) et connectés électriquement à celui-ci ; et
une plaque diffuseuse de lumière (22) disposée au-dessus des dispositifs d'éclairage (10), chacun des dispositifs d'éclairage (10) comprenant :
une puce LED (12), comprenant une surface supérieure émettrice de lumière (121) et une pluralité de surfaces latérales émettrices de lumière (122), la surface supérieure émettrice de lumière (121) étant reliée aux surfaces latérales émettrices de lumière (122) ; un encapsulant transmettant la lumière (13), recouvrant les surfaces latérales émettrices de lumière (122) et la surface supérieure émettrice de lumière (121) de la puce LED (12), et comprenant une pluralité de surfaces latérales (133) reliées les unes aux autres, une surface supérieure (131) et une surface inférieure (132) ;
une paroi transmettant la lumière (14), entourant l'encapsulant transmettant la lumière (13) et recouvrant les surfaces latérales (133) de l'encapsulant transmettant la lumière (13) ; dans lequel la paroi transmettant la lumière (14) comprend une surface latérale exposée vers l'extérieur (142), et l'indice de réfraction de l'encapsulant transmettant la lumière (13) est inférieur à l'indice de réfraction de la paroi transmettant la lumière (14) ; et
une structure de grille de connexion (11), dans laquelle la puce LED (12) est disposée sur la structure de grille de connexion (11) et est connectée électriquement à celle-ci, tandis que l'encapsulant transmettant la lumière (13) et la paroi transmettant la lumière (14) sont disposés sur la structure de grille de connexion (11),
le module d'éclairage (20) dans une direction normale à la surface supérieure émettrice de lumière (121) de la puce LED (12) du dispositif d'éclairage (10), il existe une distance verticale entre la plaque diffuseuse de lumière et le substrat de circuit, et dans une direction latérale orthogonale à la direction normale, il existe une distance latérale entre les dispositifs d'éclairage (10) ; et le rapport entre la distance verticale et la distance latérale est compris entre 0,1 et 0,8.

2. Module d'éclairage (20) selon la revendication 1, dans lequel un angle est défini entre la surface latérale (133) et la surface inférieure (132) de l'encapsulant transmettant la lumière (13) du dispositif d'éclairage (10), et cet angle est compris entre 90 degrés et 160 degrés.

3. Module d'éclairage (20) selon la revendication 1, dans lequel la paroi transmettant la lumière (14) comprend un matériau de remplissage destiné à augmenter la résistance structurelle.

4. Module d'éclairage (20) selon la revendication 1, dans lequel l'encapsulant transmettant la lumière (13) comprend un matériau photoluminescent.

5. Module d'éclairage (20) selon la revendication 1, dans lequel la surface supérieure (131) de l'encapsulant transmettant la lumière (13) est choisie parmi le groupe constitué d'une surface plane, d'une surface concave, d'une surface convexe et de toute combinaison de celles-ci.

6. Module d'éclairage (20) selon la revendication 1, dans lequel l'encapsulant transmettant la lumière (13) comprend en outre une lentille, et la lentille comprend une partie concave.

7. Module d'éclairage (20) selon la revendication 1, dans lequel chacun des dispositifs d'éclairage (10) comprend en outre une couche réfléchissante, la couche réfléchissante (15) étant située au-dessus de la surface supérieure émettrice de lumière (121) de la puce LED (12) et protégeant la surface supérieure émettrice de lumière (121) dans une direction normale à celle-ci.

8. Module d'éclairage (20) selon la revendication 7, dans lequel la couche réfléchissante (15) est disposée sur la surface supérieure (131) de l'encapsulant transmettant la lumière (13) ou sur la surface supérieure émettrice de lumière (121) de la puce LED (12).

9. Module d'éclairage (20) selon la revendication 7, dans lequel la couche réfléchissante (15) comprend une surface de protection (151), et la surface de protection (151) n'est pas plus petite que la surface supérieure émettrice de lumière (121) de la puce LED (12) ou n'est pas plus petite que la surface supérieure de l'encapsulant transmettant la lumière (13).

10. Module d'éclairage (20) selon la revendication 9, dans lequel la surface de protection (151) présente une forme circulaire, elliptique ou polygonale.

11. Module d'éclairage (20) selon la revendication 9, dans lequel la surface de protection (151) comprend une pluralité de zones transmettant la lumière.

12. Module d'éclairage (20) selon la revendication 1, dans lequel chacun des dispositifs d'éclairage (10) comprend en outre une autre puce LED (12), l'encapsulant transmettant la lumière (13) recouvrant une pluralité de surfaces latérales émettrices de lumière (122) et une surface supérieure émettrice de lumière (121) de ladite autre puce LED (12).

13. Module d'éclairage (20) selon la revendication 1, dans lequel l'encapsulant transmettant la lumière (13) et la paroi transmettant la lumière (14) comprennent chacun une résine thermoplastique ou une résine thermodurcissable.
